(19) **Europäisches Patentamt**

**European Patent Office**

**Office européen des brevets**

(11) **EP 0 677 595 B1**

(12) **EUROPEAN PATENT SPECIFICATION**

(45) Date of publication and mention
of the grant of the patent:
**01.04.1998 Bulletin 1998/14**

(51) Int Cl.⁶: **C23C 14/24**, C23C 16/50,
C23C 14/32, H01J 37/32

(21) Application number: **93902601.9**

(22) Date of filing: **30.12.1992**

(86) International application number:
**PCT/RU92/00261**

(87) International publication number:
**WO 94/16117 (21.07.1994 Gazette 1994/17)**

(54) **DEVICE FOR THE VACUUM-PLASMA TREATMENT OF ARTICLES**

ANLAGE ZUM VAKUUM-PLASMA-BEHANDLEN VON WERKSTÜCKEN

DISPOSITIF DE TRAITEMENT D'ARTICLES SOUS VIDE AU PLASMA

(84) Designated Contracting States:
**CH DE GB LI NL**

(43) Date of publication of application:
**18.10.1995 Bulletin 1995/42**

(73) Proprietor: **NAUCHNO-PROIZVODSTVENNOE
PREDPRIVATIE "NOVATEKH"
Moscow, 103055 (RU)**

(72) Inventor: **GRIGORIEV, Sergei Nikolaevich
10, Moscow, 103055 (RU)**

(74) Representative: **Füchsle, Klaus, Dipl.-Ing. et al
Hoffmann Eitle,
Patent- und Rechtsanwälte,
Arabellastrasse 4
81925 München (DE)**

(56) References cited:
**EP-A- 0 334 204         WO-A-92/19785
WO-A-92/21788         FR-A- 2 147 880
FR-A- 2 182 747         US-A- 5 037 522**

## Description

### Field of the Invention

The field of this invention is apparatus for vacuum plasma treatment of substrates.

### Prior Art

An apparatus for vacuum plasma treatment of substrates is known the apparatus comprising a direct current power supply unit connected electrically to a cathode and an anode of vacuum arc discharge that are located inside a vacuum chamber in a medium of a working gas at a reduced pressure and a holder of substrates to be treated that is located between the cathode and the anode (US,A,4,734,178).

In the mentioned above apparatus vacuum plasma treatment of substrates is carried out using ions of metal evaporated from the cathode and this results in overetching of the substrate surface that in turn results in the substrate surface finish class decrease.

It is also impossible to carry out a high quality complex treatment of long-sized substrates using the mentioned above apparatus in view of unhomogeneous plasma density distribution between the center and the ends of the substrate and this fact substantially limits technological capability of the apparatus.

Another known apparatus for vacuum plasma treatment of substrates comprises a direct current power supply unit connected electrically to a cathode of a vacuum arc discharge located inside a vacuum chamber and to the vacuum chamber serving as an anode of the discharge and a holder of substrates to be treated located inside the vacuum chamber (FR,A,2182747).

In the mentioned above apparatus vacuum plasma treatment of substrates is carried out using ions of metal evaporated from the cathode and this results in overetching of the substrate surface that in turn results in the substrate surface finish class decrease.

It is also impossible to carry out a high quality complex treatment of long-sized substrates using the mentioned above apparatus in view of unhomogeneous plasma flow distribution along the substrate that results in unhomogeneous treatment and this fact substantially limits technological capability of the apparatus.

Another known apparatus for vacuum plasma treatment of substrates comprises a vacuum chamber with an extended anode and with an extended cathode of a vacuum arc discharge located inside the chamber and electrically connected respectively to a positive and a negative poles of a discharge power supply unit and a holder of at least one substrate to be treated located between the anode and the cathode (FR,A,2147880).

The holder of at least one substrate to be treated of this apparatus is adjusted to fasten only one end of the substrate to be treated and has no current leads. The anode is extended and has one current lead.

In the mentioned above apparatus vacuum plasma treatment of substrates is carried out using ions of metal evaporated from the cathode and this results in overetching of the substrate surface that in turn results in the substrate surface finish class decrease.

It is also impossible to carry out a high quality complex treatment of long-sized substrates using this apparatus because the one-end current lead of the anode without any current lead of the holder of the substrate to be treated results in unhomogeneous plasma flow distribution along the substrate that in turn results in unhomogeneous treatment and this fact substantially limits technological capability of the apparatus. Another known apparatus for vacuum plasma treatment of substrates and including the features of the preamble of claim 1 is disclosed in WO 92/19785. The known apparatus comprises a vacuum chamber in which are located an anode and a cathode of a vacuum arc discharge electrically connected respectively to a positive pole and to a negative pole of a discharge power supply unit, a holder of at least one substrate to be treated, located between the anode and the cathode, and a screen located between the cathode and the holder of at least one substrate to be treated and being permeable to electrons and impermeable to metal ions, neutral atoms and droplets.

### Summary of the Invention.

The present invention is based on the object of making an apparatus for vacuum plasma treatment of substrates provided with a means preventing from the surface overetching of the substrate to be treated and with such an anode and such a holder of at least one substrate to be treated that could allow to keep the initial surface finish class of the substrate to be treated and to carry out a high quality complex treatment of long-sized substrates and as a result to increase substantially technological capability of the apparatus.

The object is accomplished by providing an apparatus for vacuum plasma treatment of substrates comprising a vacuum chamber, an extended anode and a cathode of vacuum arc discharge located inside the vacuum chamber and electrically connected respectively to a positive pole and to a negative pole of a discharge power supply unit and a holder of at least one substrate to be treated located between the anode and the cathode with an impermeable for metal ions screen located between the cathode and the holder of at least one substrate to be treated, the holder itself of at least one substrate to be treated is adjusted to fasten both ends of the substrate to be treated and has on every end of the substrate to be treated a current lead, both current leads being electrically connected to each other, the anode is extended in direction of the ends of the substrate to be treated and has on every its end a current lead, both current leads electrically connected to each other, the pair of current leads of the holder of at least one substrate to be treated and the pair of current leads of the anode are alternatively connectable through a switch to the positive pole of the discharge power supply unit.

The holder of one substrate to be treated may comprise two separate clamps for both ends of the substrate to be treated located on the plane perpendicular to the direction of the vacuum arc discharge current.

The holder of a number of substrate to be treated may in addition comprise two separate disks located on the both sides of all substrates to be treated and connected to the clamps, the current leads of the holder are a turnable assemblage of two pivots and an isolator between them, both pivots being passed through and connected to the disks, on one side of the substrates to be treated the clamps of their ends are planetarally movable and the clamps of the opposite ends of the substrates to be treated are turnable and reciprocatingly movable relative to their disk.

The apparatus may be provided with a means to induce a magnetic field with lines of force perpendicular to the axis of the substrate to be treated, that is located in immediate proximity to the holder of substrates to be treated and on the holder side facing the cathode.

The means to induce the magnetic field may be a solenoid.

Such construction of the apparatus allows to keep the initial surface finish class of the substrates to be treated, to carry out a homogeneous complex treatment of long-sized substrates and as a result to increase technological capability of the apparatus.

**Brief Description of the Drawings.**

The following text explains the invention by means of description of specific embodiments and by the attached drawings where:

Fig. 1 is a schematic diagram of the apparatus for vacuum plasma treatment of substrates wherein the vacuum chamber is shown in longitudinal section;
Fig. 2 is a schematic diagram of a modification of the apparatus construction wherein the vacuum chamber is shown in longitudial section;
Fig. 3 is a schematic diagram of yet another modification of the apparatus construction wherein the vacuum chamber is shown in longitudinal section, and
Fig. 4 is the same schematic diagram as presented in the Fig I but giving distribution of the tangential magnetic field strengths along the substrate to be treated.

**Detailed Description of the Invention.**

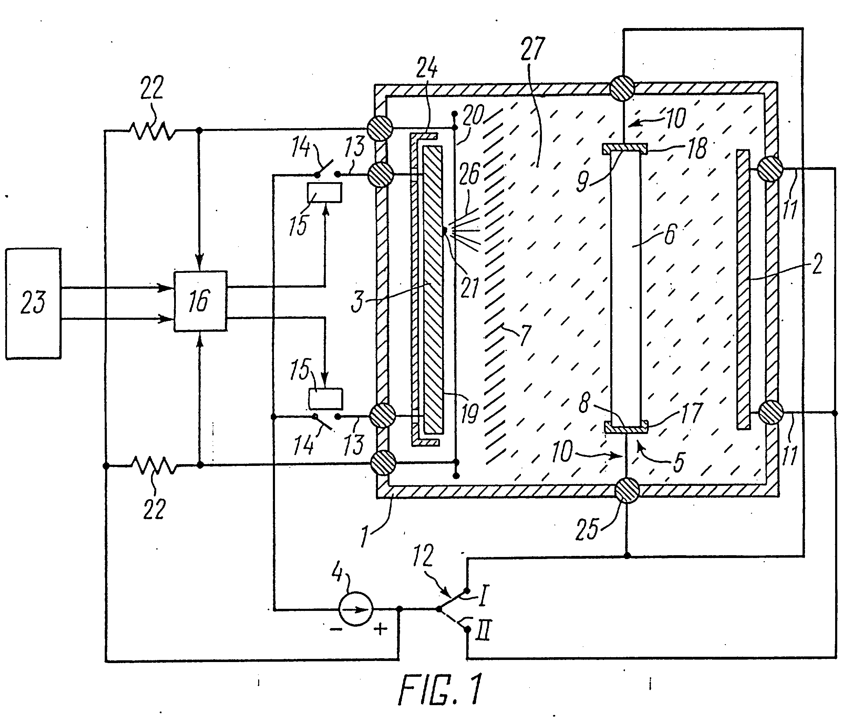

The apparatus for vacuum plasma treatment of substrates according to the invention has a vacuum chamber 1 ( (Fig.1), an extended anode 2 and an extended cathode 3 of a vacuum arc discharge located inside the chamber I and electrically connected respectively to the positive and to the negative poles of the discharge power supply unit 4 and the holder 5 of at least one substrate 6 to be treated located between -the anode 2 and the cathode 3.

Impermeable for metal ions screen 7 is located between the cathode 3 and the holder 5. The holder 5 is used for one long-sized substrate 6 to be treated. It is adjusted to fasten two ends 8 and 9 of the substrate 6 to be treated and has on every side of both ends 8 and 9 of the substrate 6 to be treated two current leads 10 that are connected electrically to each other. The anode 2 is extended in the direction of the ends 8 and 9 of the substrate 6 to be treated and on its both ends it has two current leads 11 connected electrically to each other. The pair of current leads 10 of the holder 5 and the pair of current leads 11 of the anode 2 are alternatively connectable to the positive pole of the discharge power supply unit 4 by means of the switch 12. The cathode 3 is connected to the negative pole of the discharge power supply unit 4 by means of its own pair of the current leads 13 and the switches 14 connected to them in series and controlled with two separate activating members 15 that are connected to the output of the comparison unit 16.

The holder 5 of one substrate 6 to be treated comprises two separate clamps 17 and 18 of both ends 8 and 9 respectively of the substrate 6 to be treated that are located in the plane that is perpendicular to the direction of the vacuum arc discharge current.

Near the working surface 19 of the cathode 3 the wire detector 20 of current position of the cathode spot 21 of the vacuum arc discharge is located. Through the resistors 22 it is connected to the positive pole of the discharge power supply unit 4. The detector 20 is also connected to the input of the comparison unit 16, another input of wich is connected to the programming unit 23 generating electrical control signal changing in time.

The screen 24 near the non-working surface of the cathode 3 prevents from the cathode spot 21 passing to this surface.

The current leads 10,11,13 respectively of the holder 5, of the anode 2 and of the cathode 3 as well as the current leads of the detector 20 are led out of the vacuum chamber I through the isolators 25 located on the walls of the chamber 1.

The metal-gas plasma flow is marked in the Fig.1 with the reference 26 and the pure gas plasma area is here hatched and marked with the reference 27.

The embodiment described above may by successfully used for long-sized substrates treatment especially when the treatment of only one side of the substrate surface facing the cathode is required, for instance, of a flat substrate surface.

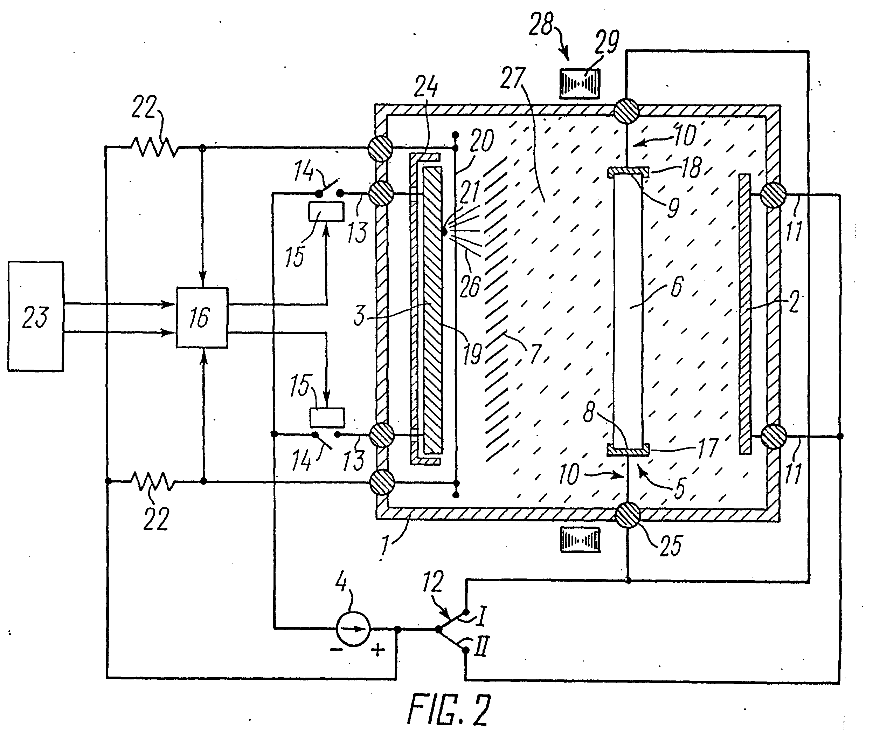

The modification of the apparatus construction presented in the Fig.2 allows to increase the productivity and the efficiency of the apparatus by means of the plasma flow concentration in the area where the substrate to be treated is located.

This embodiment is analogous to the embodiment presented in the Fig. 1.

The difference is that the apparatus presented in the Fig.2 is provided with the means 28 to induce the magnetic field its lines of force being perpendicular to the axis of the substrate 6 to be treated. The means is located in immediate proximity to the holder 5 and on the holder side facing the cathode 3.

The solenoid 29 is used as the means 28.

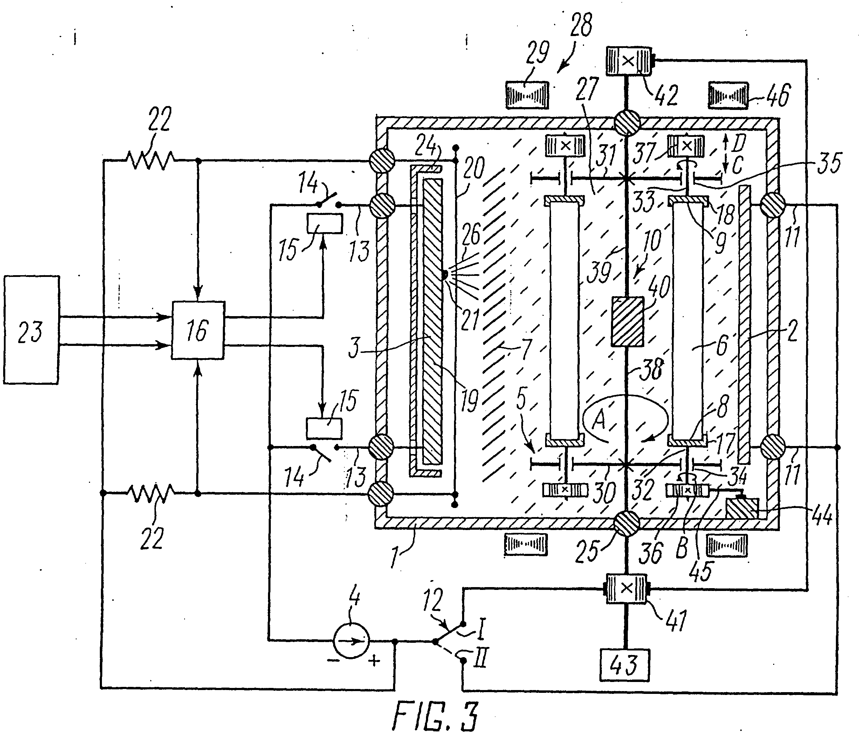

Presented in the Fig.3 modification of the apparatus construction is better to be used for treatment of a great number of the substrates 6 that are mainly of the same type.

In this case the holder 5 of a number of substrates 6 to be treated comprises in addition two separate disks 30 and 31 located respectively on the both sides of all the substrates to be treated and connected with the clamps 17 and 18 by means of the axles 32 and 33 passed respectively through the guides 34 and 35 on the disks 30 and 31. One end of each axle 32 or 33 is connected respectively with the corresponding clamp 17 or 18. The opposite ends of the axles 32 are provided with the gears 36 and the opposite ends of the axles 33 are provided with the loads 37.

The current leads 10 of the holder 5 are made as a single whole comprising two pivots 38 and 39 connected to each other by means of the isolator 40. The pivots 38 and 39 are passed through both disks 30 and 31 respectively, rigidly coupled with them and rotatable in the direction shown by the arrow A.

The ends of the pivots 38 and 39 passing out of the vacuum chamber I and serving as the current leads 10 are connected to the brush collectors 41 and 42. The pivot 38 is kinematically connected through the brush collector 41 with the output shaft of the rotation drive 43.

The clamps 17 of the ends 8 of the substrates 6 are planetarally movable in the direction shown by the arrow B. For this purpose the isolator 44 is installed inside the vacuum chamber 1. When the disk 30 rotates the gears 36 touch the stop 45 fastened on the isolator 44 and also rotate relative to the disk 30. The clamps 18 of the ends 9 of the substrates 6 are also planetarally movable because they are rotatable relative to their disk 31. They are reciprocatingly movable relative to the disk 31 in the directions shown by the arrows C and D and pressed to the ends 9 by means of the loads 37.

Thus the guides 34 serve only for rotation of the axles 32 but the guides 35 serve for rotation as well as for reciprocation of the axles 33.

In the last modification of the apparatus construction the means 28 to induce the magnetic field is located on both sides of the holder 5 facing the cathode 3 and the anode 2 and comprises two solenoids 29 and 46. This allows to concentrate the homogeneous plasma flow in space between the solenoids 29 and 46 mainly when the positive pole of the power supply unit 4 is connected to the anode 2. It is fruitful when the holder 5 of a number of the substrates is used and the substrates 6 fastened on the holder 5 are distanced in space one from another.

The operating principle of the apparatus for vacuum plasma treatment of substrates according to the invention is the following.

The vacuum chamber I (Fig.1) is pumped down to a pressure about 0.001 Pa and then it is filled with the working gas (nitrogen, argon, oxigen in the pressure range 0.1-10 Pa) using a gas input system (wich is not shown in the drawing). When the discharge power supply unit 4 is turned on the vacuum arc discharge is initiated on the working surface 19 of the cathode 3. The cathode spot 21 of the vacuum arc discharge always moves along the cathode surface towards the turned-on current lead 13. The turning on of the switches 14 is carried out using the detector 20, the resistors 22, the comparison unit 16, the programming unit 23 and the activating members 15 of the switches 14. The detector 20 and the resistors 22 form the diagonal of the Wheatstone bridge the resistance of the resistor 22 being more then one order of magnitude higher than the resistance of the detector 20. The voltage at the ends of the detector 20 is

$$U = i(r_x - R/2),$$

where $i$ is current in the circuit of the detector 20, $r_x$ is the resistance of the part of the detector between its end and the center of its section crossed by the metal-gas plasma flow 26, and R is the resistance of the detector 20.

Thus the voltage U of the detector 20 determines unambiguously the current position of the cathode spot 21 at the cathode 3.

This voltage is supplied to the first input of the comparison unit (operational amplifier) 16. To the second input is supplied the voltage from the programming unit 23. If the difference between the both input voltages of the comparison unit 16 is zero then both switches 14 are turned on and the cathode spot moves chaotically allong the cathode 3. When the cathode spot 21 shifts along the cathode 3 the voltage U of the detector 20 changes and then the difference between the voltage of the detector 20 and the voltage from the programming unit 23 differs from zero and at the output of the comparison unit 16 is generated a signal turning off one of the switches 14 by means of the activating member 15 and the cathode spot 21 starts to move in the direction that leads to a decrease of the input voltages difference. When the voltage from the programming unit 23 is constant the cathode spot reciprocates near a certain point of the cathode axis. The change of the voltage from the programming unit 23 results in the displacement of the cathode spot reciprocation zone. So if the voltage from the programming unit 23 changes according to a preset program then the position of the cathode spot 21 also changes according to the same program.

The metal-gas plasma flow 26 propagating from the cathode spot 21 reaches the screen 7 that is impermeable to metal ions. The metal ions moves rectilineally and they are neutralized and deposited on the surface of the screen 7. So the metal cannot penetrate into the space beyond the screen. But the electrons from the metal-gas plasma do penetrate into this space under the influence of the electrical field of the anode ( it may be the substrate 6 - position I of the switch 12, or the anode 2 - position II of the switch 12) and they ionize the working gas and form the positive column of the gas plasma 27.

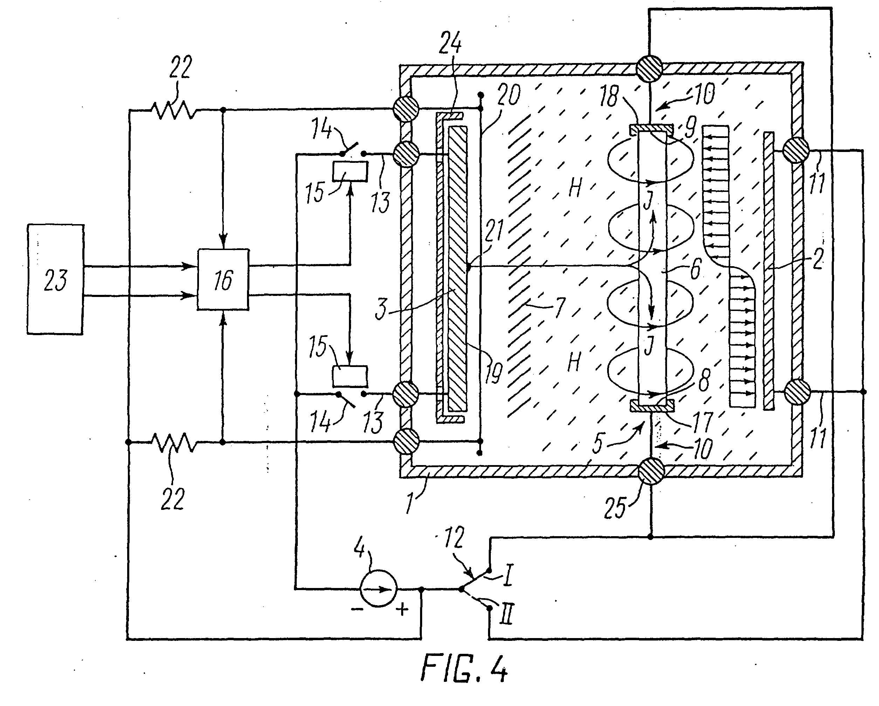

When the holder 5 has two current leads 10 as it is shown in the Fig.4 the superposition of the magnetic fields H of two currents I with opposite directions yields zero value of the magnetic field strength near the anode surface area receiving the electron current from the positive column and there is no force disturbing the positive column and displacing it along the anode in any direction.

When the cathode spot 21 moves along the cathode 3 according to any preset program then the electron flow on the surface of the substrate 6 or of the anode 2 (depending on the position of the switch 12) shifts accordingly and the vacuum plasma treatment of the substrate 6 is carried out strictly according to the program preset by the programming unit 23.

If the working gas is nitrogen the substrate 6 is heated up to the working temperature by the electron flow (the switch 12 in position I) then the temperature control system (not shown in the drawing) turns the switch 12 into position II, and the heated substrate 6 is plunged into the plasma column moving reciprocatingly and nitriding the substrate 6 according to the preset program.

When the treatment of the substrate surface with gas ions is needed the discharge is also initiated between the anode 2 and the cathode 3 and a high negative bias voltage is put to the substrate 6.

The modification of the apparatus according to Fig. 2 operates analogous to the apparatus according to Fig. 1.

The difference is that in the apparatus according to Fig.2 the correspondance of the substrate part plunged into the election flow of the positive column to the cathode spot 21 position on the cathode 3 is strengthened by means of the magnetic field with lines of force perpendicular to the axis of the substrate 6.

The solenoid 29 inducing the magnetic field partially envelops the holder 5 of the substrate 6 on the side facing the cathode 3.

In magnetic field the electrons of the gas plasma are magnetized and move along the lines of force of the magnetic field. They move in the direction that is perpendicular to the axis of the substrate 6 because the lines of force are also perpendicular to this axis.

The modification of the apparatus according to Fig. 3 operates analogous to the apparatus according to Fig. 2.

The difference is that the current in the circuit of the power supply unit 4 ( Fig.3) runs through the brush collectors 41 and 42 and through the ends of the pivots 38 and 39 separated by the isolator 40. The isolator 40 makes the pivot 39 to rotate but it prevents from the current running through the pivot 38 to the pivot 39. The substrates 6 are fastened on the holder 5. The clamps 17 of the holder 5 rotate around their axes when the disk 30 rotates and the gears 36 touch the stop 45 isolated from the chamber 1.

Thus the substrates 6 move planetarally when the disk 30 rotates.

The clamps 18 are reciprocatingly movable relative to the disk 31. It allows to connect electrically the ends 9 of the substrates 6 irrespective of their dimensions. The clamps 18 are pressed to the ends 9 of the substrates 6 by means of the loads 37 that results in a reliable electrical contact.

The solenoid 46 allows to stabilize and to concentrate the plasma flow within the whole space filled with a number of the substrates 6 to be treated.

Thus the apparatus according to the invention allows to treat the substrates keeping their initial surface finish class ( for instance, to heat in vacuum with the electron flow) and this allows in turn to coat the substrates immediately after the preheating and the holding the substrates in a preset working temperature range ( for instance, nitriding) in one and the same vacuum chamber without any grinding or polishing using for coating widely known methods of the cathode material evaparation in vacuum ( the screen is removed) or of the target material sputtering with gas ions (the screen is in the working position) that substantially increases the technological capability of the apparatus.

Besides the apparatus according to the invention allows to increase productivity of the treatment simultaneously heating a great number of massive substrates including long-sized substrates with a plasma electron flow that is homogeneously distributable during the treatment along the substrates .

## Industrial Applicability

The apparatus for vacuum plasma treatment of substrates the treatment comprising the substrate heating with plasma, the substrate surface cleaning with gas ions, the chemical heat treatment of the substrates and the coating deposition may be used for vacuum plasma treatment of mainly long-sized substrates such as shafts, tubes, long-sized tools (broaches), sets of gears, hobs and others.

## Claims

1. An apparatus for vacuum plasma treatment of substrates comprising a vacuum chamber (1) in which are located an extended anode (2) and a cathode (3) of a vacuum arc discharge electrically connected respectively to a positive pole and to a negative pole of a discharge power supply unit (4), a holder (5) of at least one substrate (6) to be treated, located between the anode (2) and the cathode (3), and a screen (7) impermeable to metal ions and located between the cathode (3) and the holder (5) of at least one substrate (6) to be treated, **characterized in that** the holder (5) of at least one substrate (6) to be treated is adjusted to fasten both ends (8, 9) of the substrate (6) to be treated and has on every end (8, 9) of the substrate (6) to be treated a current lead (10), both current leads (10) being electrically connected to each other, that the anode (2) is extended in the direction of the ends (8, 9) of the substrate (6) to be treated and has on each of its end a current lead (11), both current leads (11) being electrically connected to each other, and that the pair of current leads (10) of the holder (5) of at least one substrate (6) to be treated and the pair of current leads (11) of the anode (2) are alternatively connectable to the positive pole of the discharge power supply unit (4) by means of a switch (12).

2. An apparatus according to claim 1, wherein the holder (5) of one substrate to be treated (6) comprises two separate clamps (17,18) for both ends (8, 9) of the substrate to be treated (6) located on the plane that is perpendicular to the direction of the vacuum arc discharge current.

3. An apparatus according to claim 2, wherein the holder (5) of a number of substrate to be treated (6) comprises two separate disks (30, 31) located on the both sides of all substrates to be treated (6) and connected to the clamps (17, 18), the current leads (10) of the holder (5) are a rotatable assemblage of two pivots (38, 39) and one isolator (40) between them, both pivots (38, 39) being passed through and connected to the disks (30,31), the clamps (17) on at least one side of the substrates to be treated (6) are planetarally movable and the clamps (18) of the opposite ends (9) of the substrates to be treated (6) are rotatable and reciprocatingly movable relative to the disk (31).

4. An apparatus according to claim I or 2, or 3, wherein a means (28) is provided to induce a magnetic field with lines of force perpendicular to the axis of at least one substrate to be treated (6), the means (28) being located in immediate proximity to the holder (5) of at least one substrate to be treated (6) and at least on the holder side facing the cathode (3).

5. An apparatus according to claim 4, wherein the means (28) to induce the magnetic field is a solenoid (29).

**Patentansprüche**

1. Vorrichtung zur Vakuumplasmabehandlung von Substraten, umfassend eine Vakuumkammer (1), in der sich eine langgestreckte Anode (2) und eine Kathode (3) einer Vakuumlichtbogenentladung befinden, die entsprechend an einem Pulspol und einem Minuspol einer Entladungsstromversorgungseinheit (4) angeschlossen sind, einen Halter (5) für zumindest ein zu behandelndes Substrat (6), der zwischen der Anode (2) und der Kathode (3) liegt, und eine Abschirmung (7), die für Metallionen undurchlässig ist und zwischen der Kathode (3) und dem Halter (5) des zumindest einen zu behandelnden Substrats (6) liegt, **dadurch gekennzeichnet, daß** der Halter (5) des zumindest einen zu behandelnden Substrats (6) zum Befestigen der beiden Enden (8, 9) des zu behandelnden Substrats (6) angepaßt ist und an jedem Ende (8, 9) des zu behandelnden Substrats (6) eine Stromzuleitung (10) aufweist, wobei beide Stromzuleitungen (10) miteinander elektrisch verbunden sind, daß sich die Anode (2) in Richtung zu den Enden (8, 9) des zu behandelnden Substrats (6) erstreckt und an jedem Ende eine Stromzuleitung (11) besitzt, wobei beide Stromzuleitungen (11) miteinander elektrisch verbunden sind, und daß die zwei Stromzuleitungen (10) des Halters (5) des zumindest einen zu behandelnden Substrats (6) und die zwei Stromzuleitungen (11) der Anode (2) mittels eines Schalters (12) wahlweise mit dem Pluspol der Entladungsstromversorgungseinheit (4) verbindbar sind.

2. Vorrichtung nach Anspruch 1, in der der Halter (5) eines zu behandelnden Substrats (6) zwei einzelne Klemmen (17, 18) für beide Enden (8, 9) des zu behandelnden Substrats (6) umfaßt, die in der zur Richtung des Vakuumlichtbogenentladungstroms senkrecht liegenden Ebene liegen.

3. Vorrichtung nach Anspruch 2, in der der Halter (5) einer Anzahl zu behandelnder Substrate (6) zwei einzelne Scheiben (30, 31) umfaßt, die auf den beiden Seiten aller zu behandelnder Substrate (6) plaziert und mit den Klemmen (17, 18) verbunden sind, wobei die Stromzuleitungen (10) des Halters (5) eine drehbare Anordnung zweier Drehzapfen (38, 39) und eines dazwischen liegenden Isolators (40) ist, beide Drehzapfen (38, 39) durch die Scheiben (30, 31) hindurchgehen und damit verbunden sind, die Klemmen (17) auf zumindest einer Seite der zu behandelnden Substrate (6) planetarisch beweglich sind und die Klemmen (18) auf dem gegenüberliegenden Ende (9) der zu behandelnden Substrate (6) drehbar und zur Scheibe (31) hin- und herbewegbar sind.

4. Vorrichtung nach Anspruch 1 oder 2 oder 3, in der ein Mittel (28) vorhanden ist, um ein Magnetfeld mit senkrecht zur Achse zumindest eines zu behandelnden Substrats (6) verlaufenden Kraftlinien zu erzeugen, wobei das Mittel (28) in unmittelbarer Nähe zu dem Halter (5) von zumindest einem zu behandelnden Substrat (6) liegt und zumindest eine Seite des Halters zur Kathode zeigt.

5. Vorrichtung nach Anspruch 4, in der das Mittel (28) zum Erzeugen eines Magnetfeld ein Solenoid (29) ist.

**Revendications**

1. Appareil pour le traitement d'objets sous vide, au plasma, comportant une chambre sous vide (1) dans laquelle sont disposées une anode (2) et une cathode (3) allongées d'un dispositif de décharge à arc, sous vide, respectivement reliées à un pôle positif et à un pôle négatif d'une source (4) d'énergie de décharge, un dispositif de retenue (5) d'au moins un objet (6) à traiter, disposé entre l'anode (2) et la cathode (3), et un écran (7) imperméable aux ions métalliques et situé entre la cathode (3) et le dispositif de retenue (5) d'au moins un objet (6) à traiter, caractérisé en ce que le dispositif de retenue (5) d'au moins un objet (6) à traiter est ajusté de manière à attacher les deux extrémités (8, 9) de l'objet (6) à traiter et présente à chaque extrémité (8, 9) de l'objet (6) à traiter un conducteur de courant (10), les deux conducteurs de courant (10) étant électriquement reliés l'un à l'autre, en ce que l'anode (2) est allongée en direction des extrémités (8, 9) de l'objet (6) à traiter et présente à chacune de ses extrémités un conducteur (11), les deux conducteurs de courant (11) étant électriquement reliés l'un à l'autre, et en ce que la paire de conducteurs de courant (10) du dispositif de retenue (5) d'au moins un objet (6) à traiter et la paire de conducteurs de courant (11) de l'anode (2) peuvent être reliés en alternance au pôle positif de la source (4) d'énergie de décharge au moyen d'un commutateur (12).

2. Appareil selon la revendication 1, dans lequel un dispositif de retenue (5) d'un objet (6) à traiter comporte deux pinces (17, 18) séparées pour les deux extrémités (8, 9) de l'objet (6) à traiter, situé dans le plan perpendiculaire à la direction du courant de décharge de l'arc sous vide.

3. Appareil selon la revendication 2, dans lequel le dispositif de retenue (5) d'un certain nombre d'objets (6) à traiter comporte deux disques (30, 31) séparés situés de part et d'autre de tous les objets (6) à traiter et reliés aux pinces (17, 18), les conducteurs de courant (10) du dispositif de retenue (5) sont constitués d'un assemblage rotatif de deux pivots (38, 39) avec un isolateur (40) entre eux, les deux pivots (38, 39) traversant les disques (30, 31) et leur étant reliés, les pinces (17) d'au moins un côté des objets (6) à traiter sont mobiles selon un mouvement planétaire et les pinces (18) des extrémités (9) opposées des objets (6) à traiter sont mobiles en rotation et en va-et-vient par rapport au disque (31).

4. Appareil selon la revendication 1, 2 ou 3, dans lequel est prévu un moyen (28) pour induire un champ magnétique dont les lignes de force sont perpendiculaires à l'axe d'au moins un objet (6) à traiter, le moyen (28) étant situé à proximité immédiate du dispositif de retenue (5) d'au moins un objet (6) à traiter, et au moins du côté du dispositif de retenue tourné vers la cathode (3).

5. Appareil selon la revendication 4, dans lequel le moyen (28) pour induire le champ magnétique est un solénoïde (29).

FIG. 1

FIG.2

FIG. 3

EP 0 677 595 B1

FIG. 4